# EUROPEAN PATENT SPECIFICATION

(11) **EP 1 461 800 B1**
(45) Date of publication and mention of the grant of the patent: **16.09.2015**
(21) Application number: 02790121.4
(22) Date of filing: 13.12.2002
(51) Int. Cl.: G09G 3/36, G09G 3/20, G02F 1/1335

(54) **COLOR FLAT PANEL DISPLAY SUB-PIXEL ARRANGEMENTS AND LAYOUTS FOR SUB-PIXEL RENDERING WITH INCREASED MODULATION TRANSFER FUNCTION**
FLACHE FARBANZEIGEEINHEIT MIT SUB-PIXEL-ANORDNUNG UND SUB-PIXEL WIEDERGABE MIT ERHÖHTER MODULATIONSTRANSFER-FUNKTION
AGENCEMENTS ET DISPOSITIONS DE SOUS-PIXELS D'ECRAN PLAT COULEUR POUR RENDU DE SOUS-PIXELS AVEC FONCTION DE TRANSFERT DE MODULATION AMELIOREE

(30) Priority: 07.01.2002 US 346738 P; 13.09.2002 US 243094; 22.10.2002 US 278353; 22.10.2002 US 278352
(43) Date of publication of application: 29.09.2004
(60) Divisional application: 10184890.1
(73) Proprietor: Samsung Display Co., Ltd., Yongin-City, Gyeonggi-Do (KR)
(72) Inventor: BROWN ELLIOTT, Candice, Hellen, Vallejo, CA 95490 (US); CREDELLE, Thomas, Lloyd, Morgan Hill, CA 95037 (US); HIGGINS, Michael, Francis, Duncans Mills, CA 95430 (US)
(74) Representative: Boult Wade Tennant
(86) International application number: PCT/US2002/039864
(87) International publication number: WO 2003/060870

(56) References cited:
- EP-A- 0 671 650
- WO-A-01/29817
- JP-A- H0 378 390
- BROWN ELLIOTT C H: "REDUCING PIXEL COUNT WITHOUT REDUCING IMAGE QUALITY A NEW FPD COLOR-PIXEL ARRANGEMENT OFFERS REDUCED BLUE RESOLUTION, WHICH OFFERS A BETTER MATCH FOR HUMAN VISION AND PROMISES TO LOWER DISPLAY COST" INFORMATION DISPLAY, PALISADES INSTITUTE FOR RESEARCH SERVICES, NEW YORK, NY, US, vol. 15, no. 12, December 1999 (1999-12), pages 22-25, XP000879887 ISSN: 0362-0972

## Description

### BACKGROUND

The present application relates to means of addressing used in displays having improvemed display layouts, and, more particularly, to improved color pixel arrangements, and to data format conversion methods for these displays. In particular, the invention relates to a method as defined in claim 1 and a corresponding system as defined in claim 14. Further embodiments are defined in the dependent claims. Full color perception is produced in the eye by three-color receptor nerve cell types called cones. The three types are sensitive to different wavelengths of light: long, medium, and short ("red", "green", and "blue", respectively). The relative density of the three differs significantly from one another. There are slightly more red receptors than green receptors. There are very few blue receptors compared to red or green receptors.

The human vision system processes the information detected by the eye in several perceptual channels: luminance, chromanance, and motion. Motion is only important for flicker threshold to the imaging system designer. The luminance channel takes the input from only the red and green receptors. In other words, the luminance channel is "color blind". It processes the information in such a manner that the contrast of edges is enhanced. The chromanance channel does not have edge contrast enhancement. Since the luminance channel uses and enhances every red and green receptor, the resolution of the luminance channel is several times higher than the chromanance channels. Consequently, the blue receptor contribution to luminance perception is negligible. The luminance channel thus acts as a spatial frequency signal band pass filter. Its peak response is at 35 cycles per degree (cycles/°). It limits the response at 0 cycles/° and at 50 cycles/° in the horizontal and vertical axis. This means that the luminance channel can only tell the relative brightness between two areas within the field of view. It cannot tell the absolute brightness. Further, if any detail is finer than 50 cycles/°, it simply blends together. The limit in the horizontal axis is slightly higher than the vertical axis. The limit in the diagonal axes is somewhat lower.

The chromanance channel is further subdivided into two sub-channels, to allow us to see full color. These channels are quite different from the luminance channel, acting as low pass filters. One can always tell what color an object is, no matter how big it is in our field of view. The red/green chromanance sub-channel resolution limit is at 8 cycles/°, while the yellow/blue chromanance sub-channel resolution limit is at 4 cycles/°. Thus, the error introduced by lowering the red/green resolution or the yellow/blue resolution by one octave will be barely noticeable by the most perceptive viewer, if at all, as experiments at Xerox and NASA, Ames Research Center (see, e.g., R. Martin, J. Lille, J. Larimer, Detestability of Reduced Blue Pixel Count in Projection Displays, SID Digest 1993) have demonstrated.

The luminance channel determines image details by analyzing the spatial frequency Fourier transform components. From signal theory, any given signal can be represented as the summation of a series of sine waves of varying amplitude and frequency. The process of teasing out, mathematically, these sine-wave-components of a given signal is called a Fourier Transform. The human vision system responds to these sine-wave-components in the two-dimensional image signal.

Color perception is influenced by a process called "assimilation" or the Von Bezold color blending effect. This is what allows separate color pixels (also known as sub-pixels or emitters) of a display to be perceived as a mixed color. This blending effect happens over a given angular distance in the field of view. Because of the relatively scarce blue receptors, this blending happens over a greater angle for blue than for red or green. This distance is approximately 0.25° for blue, while for red or green it is approximately 0.12°. At a viewing distance of twelve inches, 0.25° subtends 50 mils (1,270 µ) on a display. Thus, if the blue pixel pitch is less than half (625 µ) of this blending pitch, the colors will blend without loss of picture quality. This blending effect is directly related to the chromanance sub-channel resolution limits described above. Below the resolution limit, one sees separate colors, above the resolution limit, one sees the combined color.

EP-A-0 671 650 discloses a method for determining a pixel layout pattern for a display having a plurality of pixels, each pixel having a plurality of independently illuminable areas, each area being assigned to one of a plurality of primary color components. The method comprises at least the step of allocating the independently illuminated areas to the primary color components in a ratio such that the condition of the illuminated areas to one color component is different from that of the other color component. EP-A-0 671 650 discusses references which disclose a pixel pattern arrangement where sub-pixels of varying size are used in relation to monochrome displays, and further discusses a reference to the use of sub-pixels of varying size. JP03 078390 discloses a subpixel arrangement comprising red, green and blue subpixels as an 8 subpixel repeating group. It further discusses the possibility of controlling the polarity of the subpixels.

### BRIEF DESCRIPTION OF THE DRAWINGS

The accompanying drawings, which are incorporated in, and constitute a part of this specification illustrate various implementations and embodiments disclosed herein.
Figure 1A shows an arrangement of four-color pixel elements in an array, in a single plane, for a display device, having a repeat cell consisting of eight sub-pixels.
Figure 1B shows an arrangement of three-color pixel elements in an array, in a single plane, for a display device, having a repeat cell of consisting of eight sub-pixels generated by selecting and defining four of the eight sub-pixels of Figure 1A as the same color.
Figure 1C shows an arrangement of three-color pixel elements in an array, in a single plane, for a display device, having a repeat cell of consisting of eight sub-pixels generated by selecting and defining four of the eight sub-pixels of Figure 1A as the same color and reducing their widths.
Figure 2 shows a schematic of an electronic drive arrangement for the arrangement of sub-pixels shown in Figures 1A, 1B, and 1C.
Figures 3A and 3B illustrate the relative polarities of active matrix dot inversion drive methods for a Liquid Crystal Display using the arrangement of color sub-pixels of Figure 1C and the drive arrangement of Figure 2.
Figures 4A, 4B, 4C, and 4D illustrate a set of green, blue, and red resample areas separately and overlaid, respectively, for the arrangement of sub-pixels of Figure 1C.
Figures 5A, 5B, 5C, and 5D illustrate the set of green, blue, and red resample areas of Figures 4A, 4B, 4C, and 4D respectively, overlaid on the arrangement of sub-pixels of Figure 1C to show their relative positions.
Figure 5E illustrates two logical pixels displayed on the arrangement of Figure 1C, resulting from the sub-pixel rendering operation of the resample areas of Figure 4D.
Figure 6A illustrates two logical pixels displayed on the arrangement of Figure 1C, resulting from the sub-pixel rendering operation of the resample areas of Figure 6D.
Figures 6B, 6C, and 6D illustrate a set of blue and red resample areas separately, and overlaid along with the green resample areas illustrated in Figure 4A on arrangement of sub-pixels of Figure 1C, respectively.
Figure 7A illustrates the set of green, blue, and red resample areas of Figures 4A, 4B, and 4C respectively, overlaid show their relative positions.
Figure 7B illustrates the arrangement of resample areas of Figure 7A overlaid on the arrangement of sub-pixels of Figure 1C to show their relative positions.
Figures 8A and 8B show other embodiments of the octal subpixel arrangement with various vertical displacements of the subpixels.
Figures 9A and 9B show yet other embodiments of the octal subpixel arrangement of various displacements of the split majority subpixel within the subpixel grouping.
Figure 10 depicts a system incorporating sub-pixel rendering techniques suitable to drive a panel made in accordance with the various embodiments described herein.
Figures 11A and 11B depict two particular embodiments of flowcharts to perform software and hardware sub-pixel rendering on a suitable display.
Figure 12 is one particular embodiment of an implementation of a display made in accordance with several embodiments herein disclosed.

### DETAILED DESCRIPTION

Reference will now be made in detail to implementations and embodiments of the invention, examples of which are illustrated in the accompanying drawings. Wherever possible, the same reference numbers will be used throughout the drawings to refer to the same or like parts.

### Sub-Pixel Arrangements

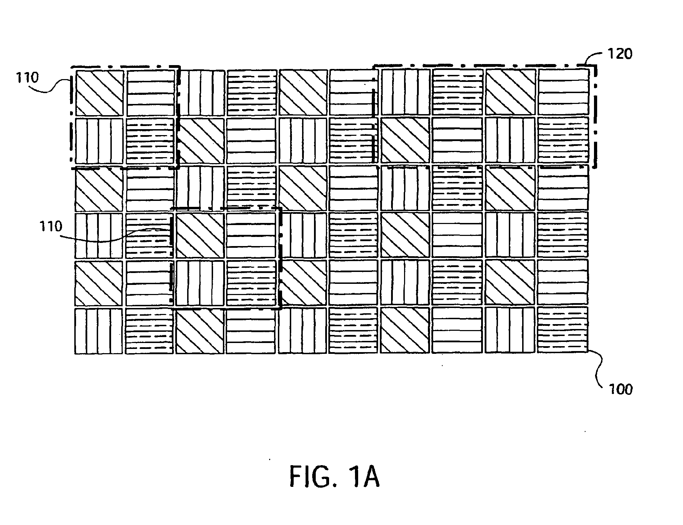

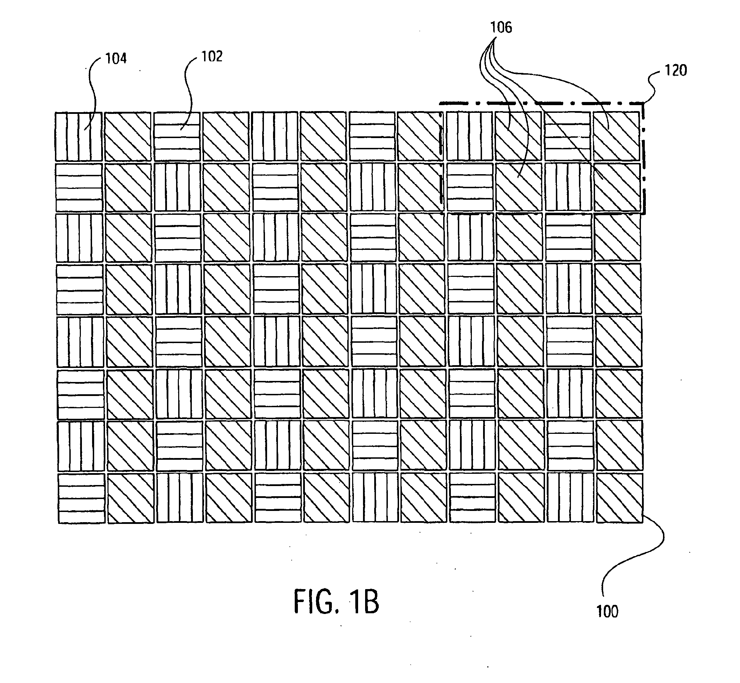

Figure 1A shows an arrangement of sub-pixel emitters 100 having four color emitters in groupings 110 that is shifted down every other column group by one sub-pixel. This creates a larger rectilinearly repeating cell group 120 of eight sub-pixels. This layout was introduced in United States Patent Application No. 2004/0051724 (the '724 application). Also disclosed in the '724 application is the practice of setting a plurality of the sub-pixels within the repeat cell to the same color point, an example of which is illustrated in Figure 1B, wherein four of the emitters 106 in the eight emitter repeat cell group 120 are set to the same color. For example, these four emitters 106 may be set to be luminance adjusted (i.e. balanced) green in color. For example, the other sub-pixel emitters may be set to be red 104 and blue 102. The luminance balanced green 106 sub-pixels have twice the area, i.e., "real-estate," per color as the red 104 and blue 102 sub-pixels, but being balanced to have the same luminance as the red 104 sub-pixels, the total green energy is balanced to produce a pleasing white point when all sub-pixels are illuminated fully. The manner of balencing the luminance of the green color sub-pixel was previously disclosed in the '724 application.

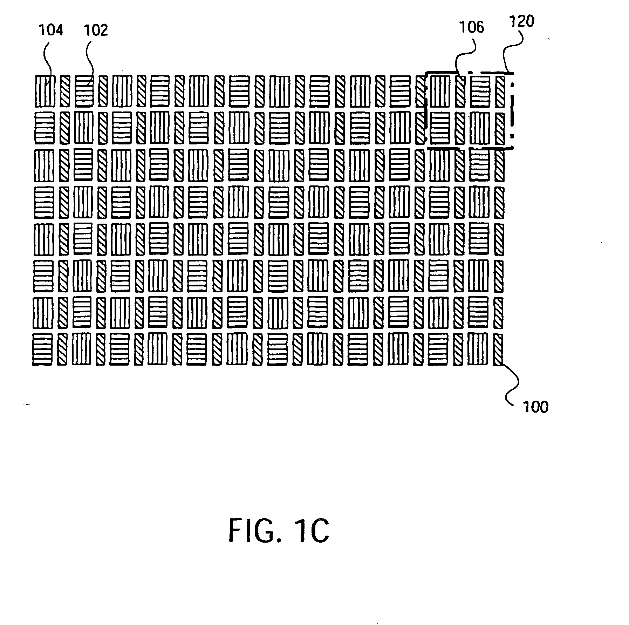

In Figure 1C, the four sub-pixel emitters 106 are reduced in size and aspect ratio compared to the other two sub-pixel emitters 104 and 102. The minority sub-pixels 104 and 102 may also be adjusted in aspect ratio. In this example, the relative size of sub-pixel 106 is adjusted to be one half of that of sub-pixels 104 or 102. As before, the colors may be assigned as desired. It should also be noted that although the repeat octal grouping is shown that the majority color sub-pixels occupy the second and fourth columns, it also suffices that the majority sub-pixels could occupy the first and the third columns as well.

In another embodiment, the colors are assigned as red 104, blue 102, and non-luminance balanced green 106. Since there are twice as many green 106 as there are of the other two colors, red 104 and blue 102, the result is a pleasing white point when all sub-pixels are illuminated fully.

In this or another color assignment embodiment, the sub-pixel aspect ratios may be adjusted so that the display array 100 consists of square repeat cell groups 120. This will put the majority color sub-pixel emitter 106 on a square grid. It will also put the minority color sub-pixel emitters 102 and 104 on, or nearly on, an idealized "checkerboard". For an example of another color assignment embodiments, sub-pixels 106 could be assigned the color red and sub-pixels 104 could be assigned the color green in Figures 1B and 1C. Under this color assignment, the algorithms for sub-pixel rendering discussed below would work similarly.

Not only may the green or the red sub-pixels occupy the majority colored sub-pixels in octal grouping 120; but the blue sub-pixels may also occupy the majority sub-pixels. Thus, all three colors - red, green, and blue - may occupy the majority sub-pixel position in this grouping. Additionally, while the colors - red, green and blue - have been used for the purposes of illustrating the present embodiments, it should be appreciated that another suitable choice of three colors - representing a suitable color gamut for a display - may also suffice for the purposes of the present invention.

As shown in Figures 1A, 1B and 1C, the subpixels appear to have a substantially rectangular appearance. It should be appreciated that other shapes to the subpixels are also possible and are contemplated within the scope of the present invention. For example, a multitude of other regular or irregular shapes for the subpixels are possible and are desirable if manufacturable. It suffices only that there is an octal grouping of colored subpixels in the fashion herein described that may be addressable for the purposes of subpixel rendering (SPR).

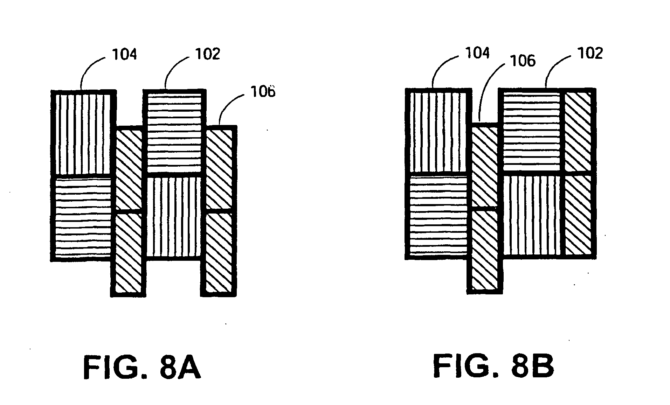

As subpixel shapes may vary under the scope of the present invention, so too may the exact positions of the subpixels be varied under the scope of the present invention. For example, Figures 8A and 8B depict a similar octal subpixel grouping wherein one or both of the majority stripes 106 are offset (relatively or otherwise) from the other subpixels 102 and 104. Other vertical offsets are also possible.

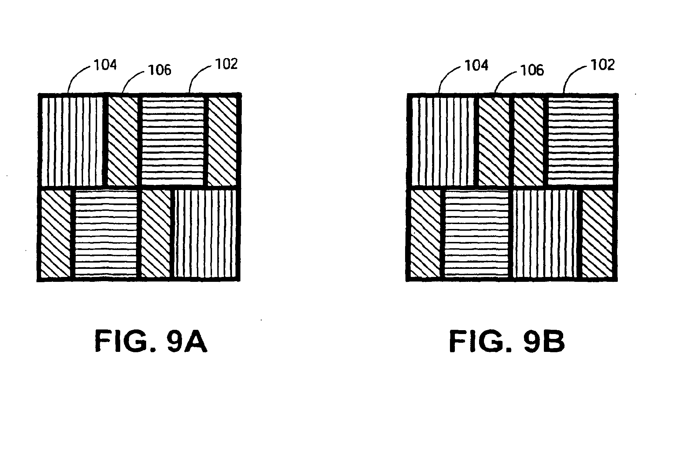

Other embodiments of the octal groupings are also possible. Figures 9A and 9B depict octal groupings wherein the majority subpixels 106 are interspersed within the checkerboard of subpixels 102 and 104. Other arrangements of majority subpixel placement within such a checkerboard are also possible and are contemplated within the scope of the present invention.

Figures 9A and 9B may have column electrodes that zigzag across the display. Column driver savings should be one third when compared to the RGB stripe system with the same resolution and the number of subpixels are about two thirds of the number of subpixels when compared to the RGB stripe system.

Yet other embodiments of the present invention are possible. For example, the entire octal subpixel groupings may be rotated 90 degrees to reverse the roles of row and column driver connections to the grouping. Such a horizontal arrangement for subpixels is further disclosed in the co-pending application entitled "COLOR DISPLAY HAVING HORIZONTAL SUB-PIXEL ARRANGEMENTS AND LAYOUTS" which is published as United States Patent Application No 2003/0090581.

The alternating "checkerboard" of emitters is similar to the red and green "checkerboard" that was disclosed in co-pending U.S. Patent Application No. 2002/0015110 ("the '110 application"), entitled "ARRANGEMENT OF COLOR PIXELS FOR FULL COLOR IMAGING DEVICES WITH SIMPLIFIED ADDRESSING," filed on July 25, 2001, using sub-pixel rendering such as that described in co-pending U.S. Patent Application No. 2003/0103058 ("the '058 application"), entitled "METHODS AND SYSTEMS FOR SUB-PIXEL RENDERING WITH GAMMA ADJUSTMENT," filed on May 17, 2002. The methods described in the above co-pending applications may be modified for the embodiments disclosed herein.

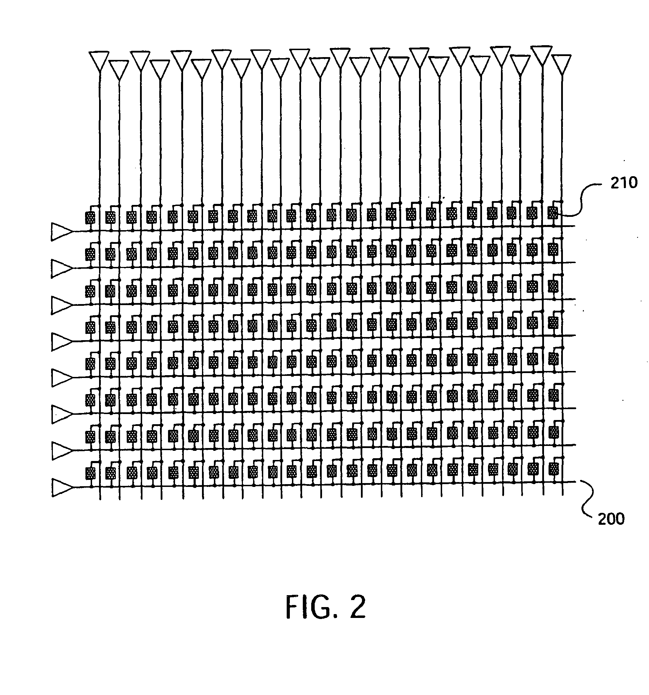

Figure 2 illustrates a schematic for a driver arrangement 200 for the arrangement of color emitter sub-pixels in Figures 1A, 1B, and 1C. For convenience, the example given has the same number of sub-pixels illustrated as Figure 1C. This drive arrangement may be used for a number of display technologies, as the blocks 210 may represent one or several electrical components, which are not shown so as not to obscure the embodiments. In particular, they may represent the capacitive display cell element for passively addressed Liquid Crystal Display (LCD), or ElectroLuminescent (EL) Display. They may represent the gaseous discharge element in a Plasma Display Panel (PDP). They may represent the semiconductor diode element of a passively addressed Inorganic Light Emitting Diode or an Organic Light Emitting Diode Display. They may also represent the transistor, storage capacitor, and capacitive cell element of an Active Matrix Liquid Crystal Display (AMLCD). They may further represent the multi-transistor, storage capacitor, and light emitting element of an Active Matrix Organic Light Emitting Diode Display (AMOLED). The may also represent, in general, the color sub-pixel and its associated electronic elements found in other known or yet to be developed display technologies.

The drive timing and method may be any of those known in the an for N X M drive matrices as those shown. However, there may be modifications needed due to the specific color assignments, particularly any checkerboard across the panel or color alternations within a single column. For example, the technique known in the art as "Multi-Row Addressing" or "Multi-Line Addressing" for passive LCD may be modified such that groupings of rows are restricted to odd and even row combinations. This will reduce potential color crosstalk since, within a column with two alternating color sub-pixels, only one color will be addressed at a time.

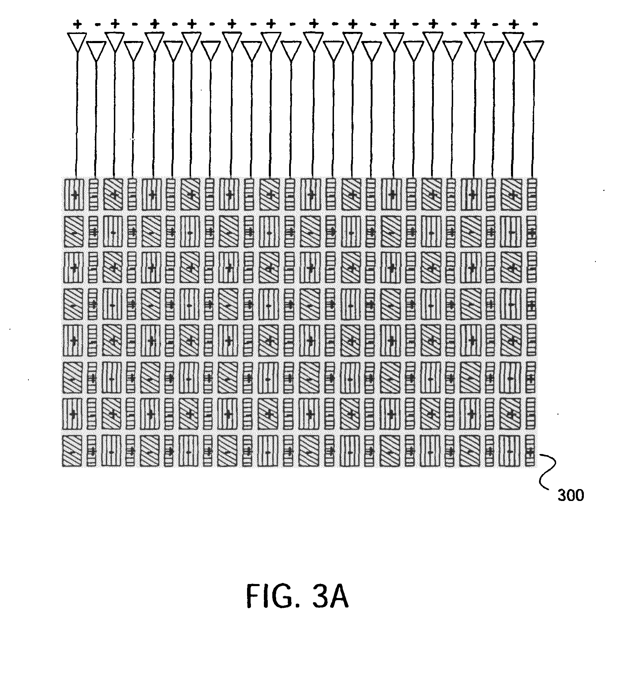

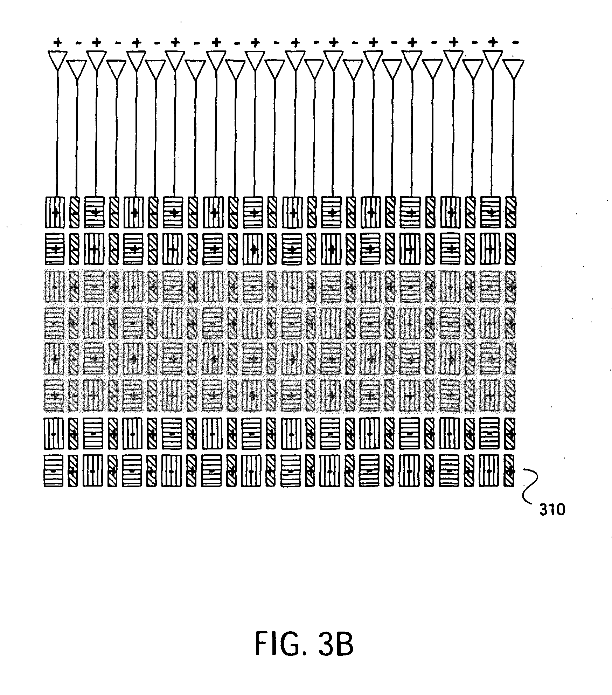

Inversion schemes, switching the electrical field polarity across the display cell to provide a time averaged zero net field and ion current across the cell, can be applied to the embodiments disclosed herein. Figures 3A and 3B show two "dot inversion" schemes 300 and 310, referred to as "1x1" and "2x1", respectively, on Active Matrix Liquid Crystal Displays, both of which will perform satisfactorily. The scheme shown on Figure 3B may perform better when slight imbalances of light transmission occur between positive and negative polarities, especially when the eye is tracking the motion of displayed images moving across the screen. Each of the Figures shows the polarities during half of the display addressing fields. The polarities are reversed for the other half, alternating every field, resulting in a net zero current (zero DC bias), as is well known in the art.

### Data Format Conversion

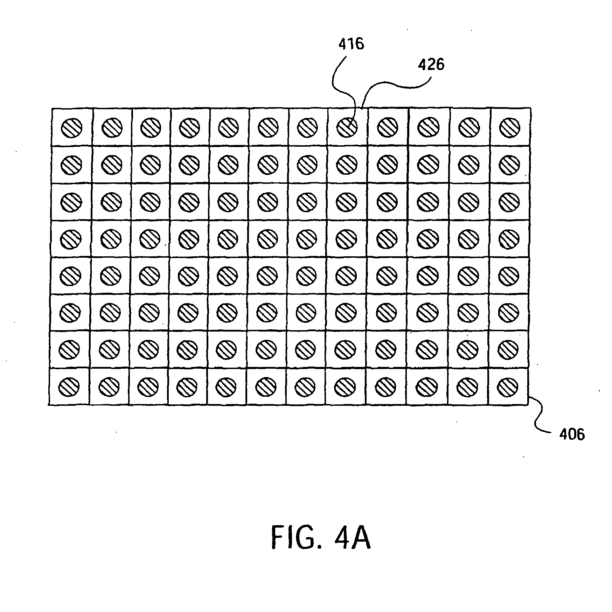

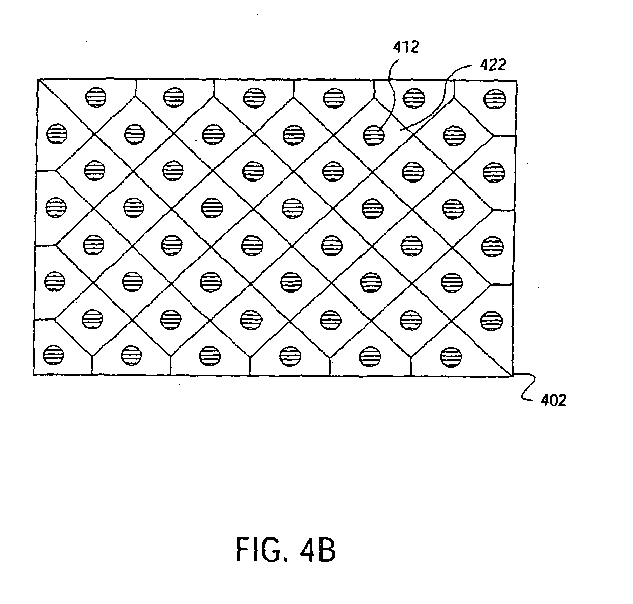

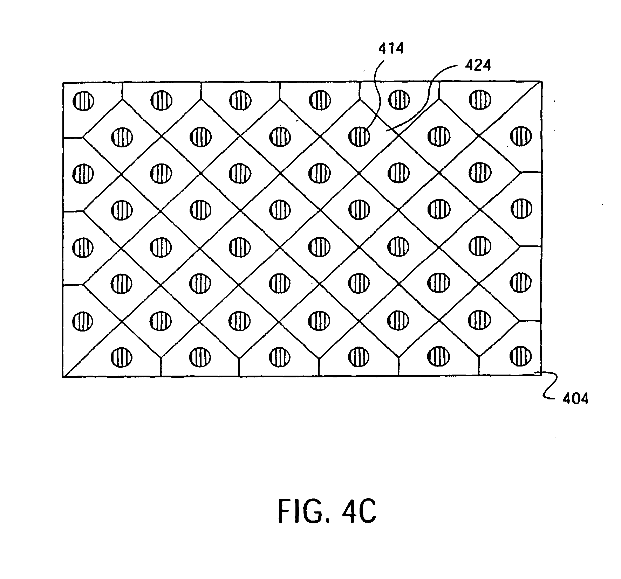

For one embodiment of data format conversion using area resampling techniques, Figures 4A, 4B, and 4C illustrate green 406, blue 402, and red 404 resample area arrays for the green, blue, and red color planes, respectively. Note that each color resample area array 406, 402, and 404 consists of resample areas 426, 422, and 424 and that each resample area has an associated resample point 416, 412, and 414, respectively, associated with it. The resample points 416, 412, and 414 match the relative positions of the green 106, blue 102, and red 104 sub-pixel locations respectively, within each color plane; but not necessarily their exact inter-color-plane-phase relationships. It should be appreciated that any number of phase relationships are also possible.

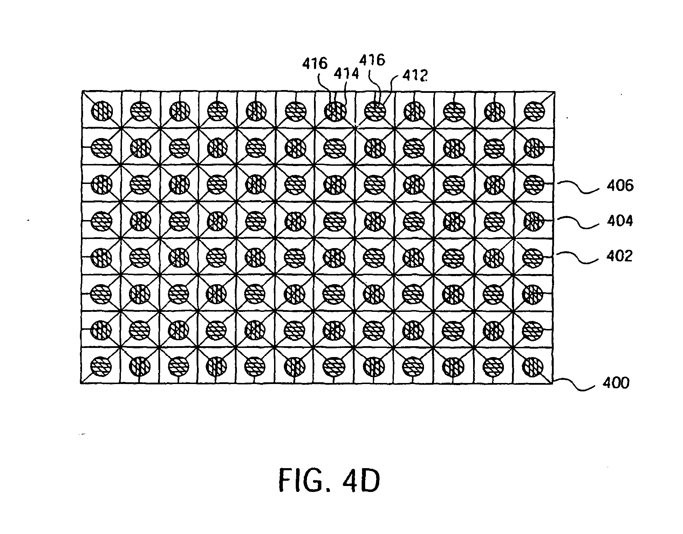

Figure 4D illustrates one particular inter-color-plane-phase relationship 400. This relationship might be employed to convert the conventional fully converged square grid RGB format which is to be displayed "one-to-one" with the square green 106 sub-pixel grid of Figure 1C. In this inter-color-plane-phase relationship 400, the green 406, blue 402, and red 404 resample area arrays are substantially positioned such that the red 414 and blue 412 resample points overlap the green 416 sample points. This treats the green sub-pixels 106 as though they lay on top of, or intimately associated with, the red 104 and blue 102 sub-pixel checkerboard.

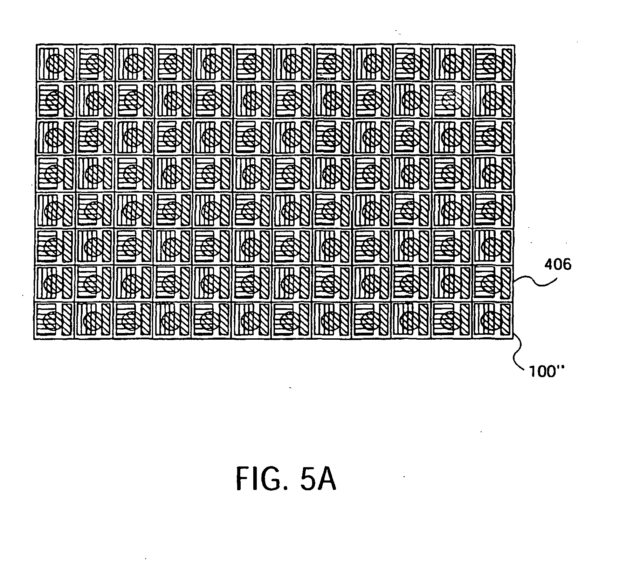

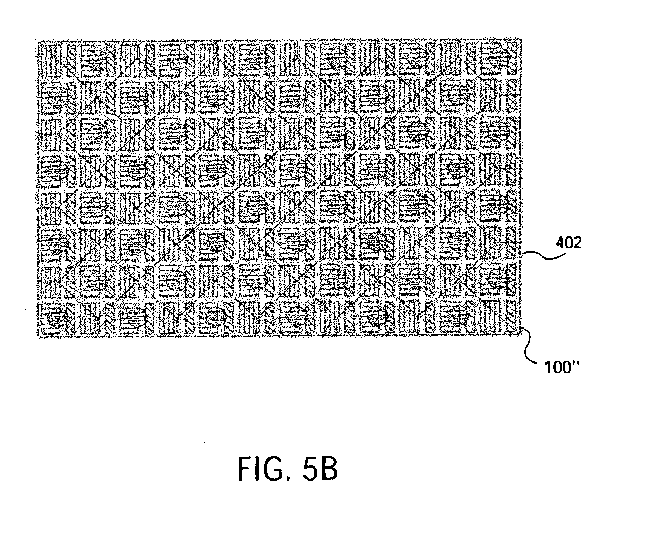

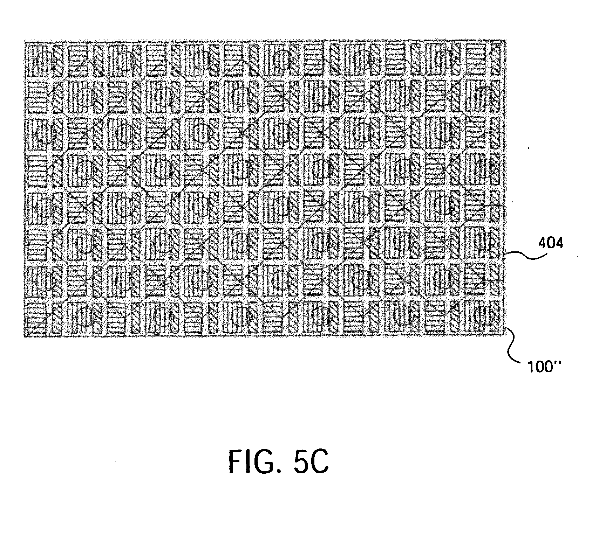

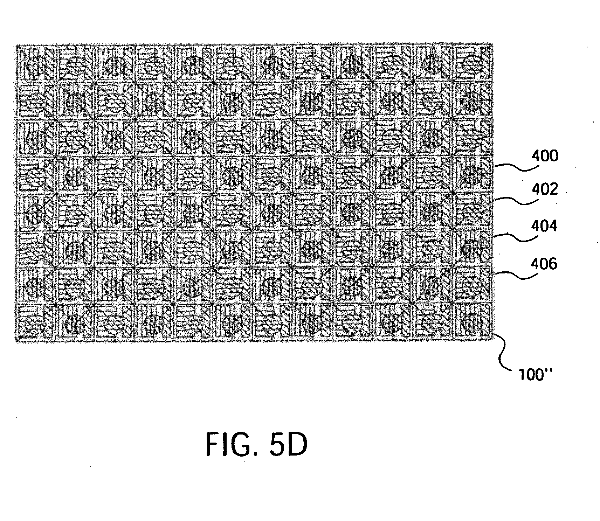

Figures 5A, 5B, and 5C illustrate the green 406, blue 402, and red 404 resample area arrays of Figures 4A, 4B, and 4C overlaid on the sub-pixel arrangement 100 of Figure 1C, respectively, with the inter-color-plane-phase relationship 400 of Figure 4D. Figure 5D illustrates the inter-color-plane-phase relationship 400 of Figure 4D overlaid on the sub-pixel arrangement 100 of Figure 1C. These Figures are merely illustrative and only serve to provide an understanding of the relationship between the resample points, reconstruction points, resample areas, and sub-pixel locations for this embodiment.

The above referenced '058 patent application describes the method used to convert the incoming data format to that suitable for the display. In such a case, the method proceeds as follows: (1) determining implied sample areas for each data point of incoming three-color pixel data; (2) determining a resample area for each color sub-pixel in the display; (3) forming a set of coefficients for each resample area, the coefficients comprising fractions whose denominators are a function of the resample area and whose numerators are a function of an area of each implied sample area that may partially overlap the resample area; (4) multiplying the incoming pixel data for each implied sample area by the coefficient resulting in a product; and (5) adding each product to obtain luminance values for each resample area.
Examining a "one-to-one" format conversion case for the resample operation illustrated in Figure 4D and 5D, the green plane conversion is a unity filter. The red and blue color planes use a 3 X 3 filter coefficient matrix, derived as explained in detail in the '058 application:

| | | |
|---|---|---|
| 0 | 0.125 | 0 |
| 0.125 | 0.5 | 0.125 |
| 0 | 0.125 | 0 |

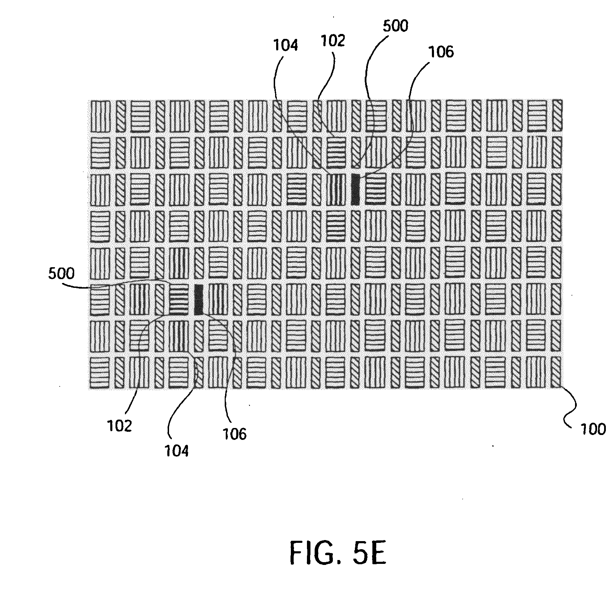

Figure 5E illustrates the results of turning on two full color incoming data pixels. The two pixels are converted to two clusters of sub-pixels, called "logical pixels" 500, turned on at varying amplitudes. One of the logical pixels is centered on or near a red sub-pixel 104. The green sub-pixel 106 is set at 100% illumination. The red sub-pixel 104 is set to 50% illumination, while the four surrounding blue sub-pixels 102 are set to 12.5% each. The result is a white dot visible to the human eye, centered between the red 104 and the green 106 sub-pixels. The other logical pixel 500 similarly has the green sub-pixel 106 set to 100% and the near by blue sub-pixel 102 set to 50% with the four surrounding red sub-pixels 104 set at 12.5% each.

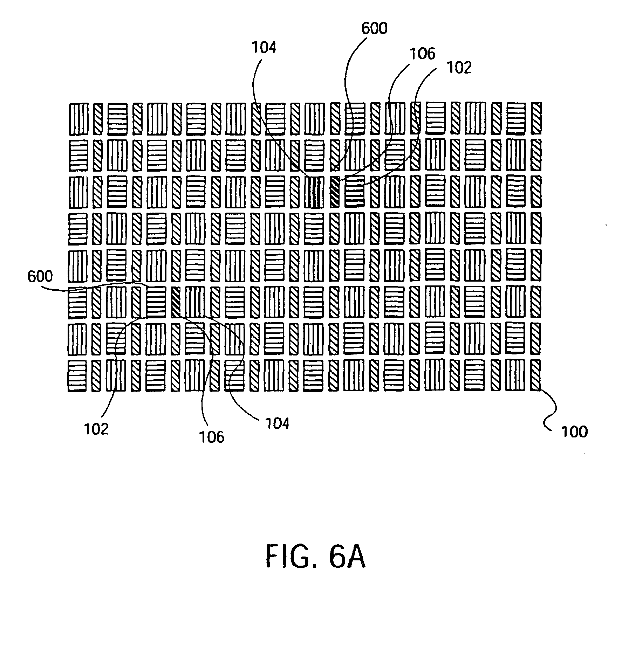

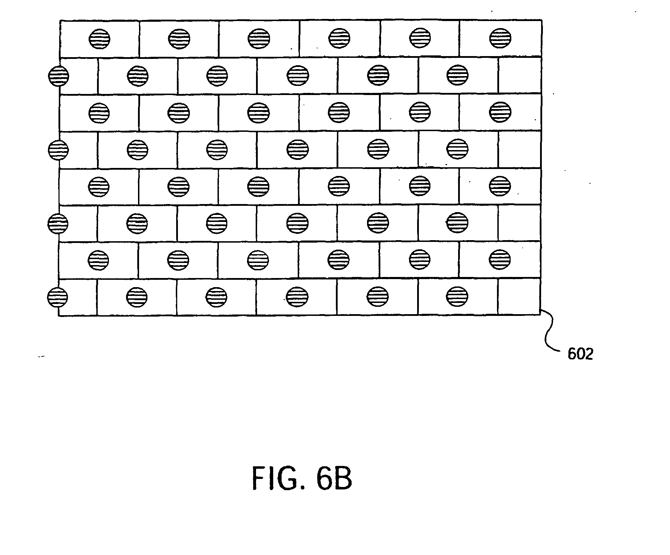

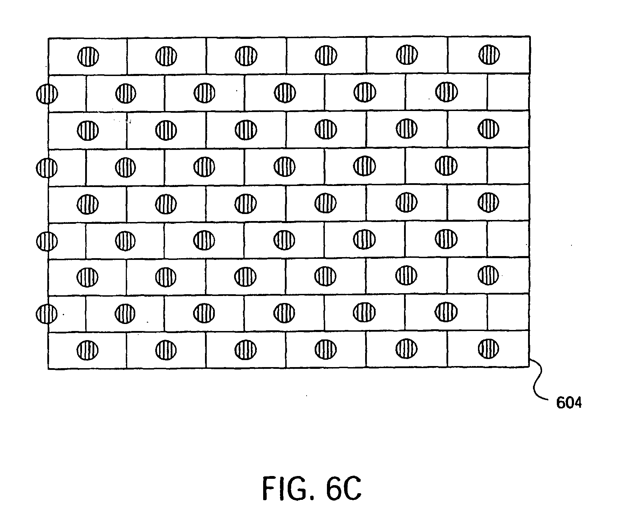

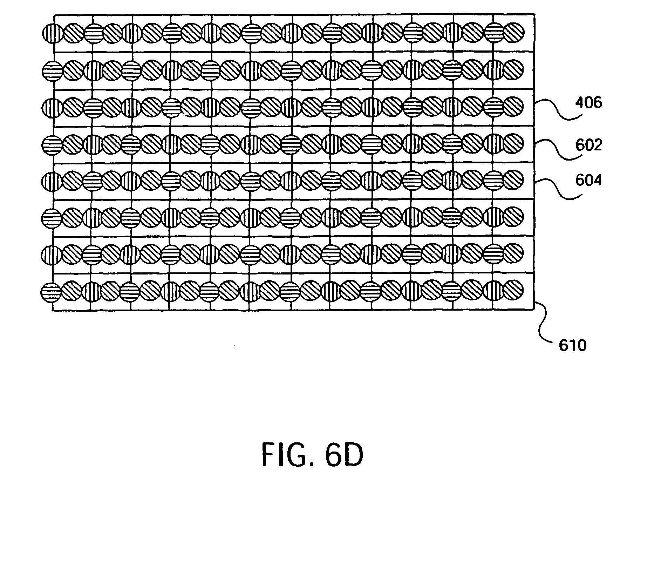

Figures 6B and 6C show an alternative blue color plane resample area array 602 and an alternative red color plane resample area array 604, respectively - shown herein as box filters ([0.5 0.5]) -- to replace the blue and red resample area arrays 402 and 404 of Figures 4B and 4C, respectively. Figure 6D illustrates an inter-color-plane-phase relationship 610 using the green resample area array 406 of Figure 4A, and blue and red resample area arrays 602 and 604. Figure 6A shows the logical pixels 600 that result from turning on two input data format pixels using the resample operation of the intercolor-plane-phase relationship 610 (Figure 6D) from input data with a "one-to-one" pixel to green sub-pixel 106 mapping. These logical pixels 600 may be in the same relative positions as the two logical pixels 500 in Figure 5E. Also, it may be possible to center the green box filter to match substantially an input pixel by adjusting the grid slightly.

Adaptive filtering techniques can also be implemented with the pixel arrangements disclosed herein, as further described below.

Again, the green resample uses a unitary filter. The red and blue color planes use a very simple 1 X 2 coefficient filter: [0.5 0.5]

An adaptive filter, similar to that disclosed in the co-pending U.S. Patent Application No. 2003/0085906 ("the '906 application"), entitled "METHODS AND SYSTEMS FOR SUB-PIXEL RENDERING WITH ADAPTIVE FILTERING," filed on August 8, 2002, can be adopted so as not to require a 3x3 sample of input data, which uses a minimum of two lines of memory. The test may be based on a smaller sample of input data, for example 1x3 or 1x2 matrices. The green data is sampled to test for vertical or diagonal lines and then the red and blue data adjacent to the green test point may be changed.

So, an adaptive filter test could be implemented as follows to test to see if a high contrast edge is detected: compare the green data (G) to a min value and a max value - if G < min or G > max, then a register value is set to 1, otherwise the register value is set to 0; compare the register values for three successive green data points to test masks to see if an edge is detected; if detected then take an appropriate action to the red and/or blue data - e.g. apply gamma or apply a new value or different filter coefficient.

The following table is illustrative of this embodiment:

| Data (for 3 successive points | 0.98 | 0.05 | 0.0 |
|---|---|---|---|
| Low Test (G < 0.1) | 0 | 1 | 1 |
| High Test (G > 0.9) | 1 | 0 | 0 |
| Compare low and NOT high | True | True | True |

For the example above, an edge has been detected and there is an array of options and/or actions to take at this point. For example, the gamma correction could be applied to the output of the box filter for red and/or blue; or a new fixed value representing the output required to balance color could be used; or use a new SPR filter.

The test for black lines, dots, edges and diagonal lines are similar in this case, since only three values are examined:

| | Register Value | | | Binary no. |
|---|---|---|---|---|
| 1. | 1 | 0 | 1 | 5 |
| 2. | 1 | 1 | 0 | 6 |
| 3. | 0 | 1 | 1 | 3 |

In the above table, the first row could represent a black pixel with white pixels on either side. The second row could represent an edge of a black line or dot. The third row could represent an edge of a black line in a different location. The binary numbers are used as an encoding for the test.

The test for white lines, dots, edges, and diagonal lines might be as follows:

| | Register Value | | | Binary no. |
|---|---|---|---|---|
| 4. | 0 | 1 | 0 | 2 |
| 5. | 0 | 0 | 1 | 1 |
| 6. | 1 | 0 | 0 | 4 |

If the tests are true and the high and low tests are, for example, 240 and 16 (out of 255) respectively, then the output value for these edges using the box filter might be 128 +/- 4 - or some other suitable value. The pattern matching is to the binary numbers shown adjacent to the register values. A simple replacement of 128 raised to an appropriate gamma power could be output to the display. For example, for gamma = 2.2, the output value is approximately 186. Even though the input may vary, this is just an edge correction term so a fixed value can be used without noticeable error. Of course, for more precision, a gamma lookup table could likewise be used. It should be appreciated that a different value, but possibly similar, of correction could be used for white and black edges. It should likewise be appreciated that as a result of detecting an edge, the red and/or blue data could be acted on by a different set of filter coefficients --- e.g. apply a [1 0] filter (i.e. unity filter) which would effectively turn off sub pixel rendering for that pixel value.

The above tests were primarily for a green test, followed by action on red and blue. Alternatively, the red and blue can be tested separately and actions taken as needed. If one desired to only apply the correction for black and white edges, than all three color data sets can be tested and the result ANDed together.

A further simplification could be made as follows. If only two pixels in a row are tested for edges, then the test above is further simplified. High and low thresholding may still be accomplished. If [0 1] or [1 0] is detected, then a new value could be applied - otherwise the original value could be used.

Yet another simplification could be accomplished as follows (illustrated for the red): subtract the red data value, Rₙ, from the red value immediately to the left, Rₙ₋₁,; if the delta is greater than a predetermined number - say for example 240 - then an edge is detected. If an edge is detected, one could substitute a new value, or apply gamma, output the value Rₙ to the display, or apply new SPR filter coefficients; otherwise, if no edge is detected, output the results of the box filter to the display. As either Rₙ or Rₙ₋₁ may be larger, the absolute value of the delta could be tested. The same simplification could occur for the blue; but the green does not need to be tested or adjusted, if green is the split pixel in the grouping. Alternatively, a different action could be taken for falling edges (i.e. Rₙ - Rₙ₋₁ < 0) and rising edges (i.e. Rₙ - Rₙ₋₁ > 0).

The results are logical pixels 600 that have only three sub-pixels each. For a white dot and using a box filter for red and blue data, the green sub-pixels 106 are set to 100% as before. The nearby red 104, as well as the nearby blue 102, could be all set to 50%. The resample operation of inter-color-plane-phase relationship 610 of Figure 6D is very simple and inexpensive to implement, while still providing good image quality.

Both of the above data format conversion methods match the human eye by placing the center of logical pixels at the numerically superior green sub-pixels. The green sub-pixels are each seen as the same brightness as the red sub-pixel, even though half as wide. Each green sub-pixel 106 acts as though it were half the brightness of the associated logical pixel at every location, while the rest of the brightness is associated with the nearby red sub-pixel illuminated. Thus, the green serves to provide the bulk of the high resolution luminance modulation, while the red and blue provide lower resolution color modulation, matching the human eye.

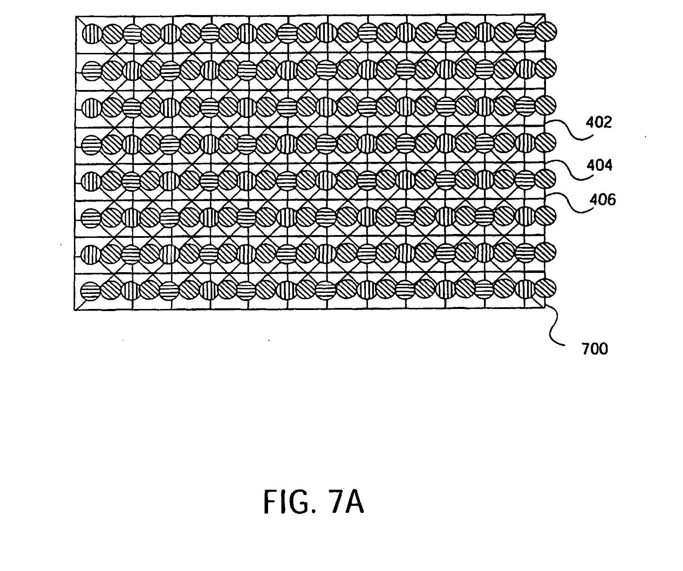

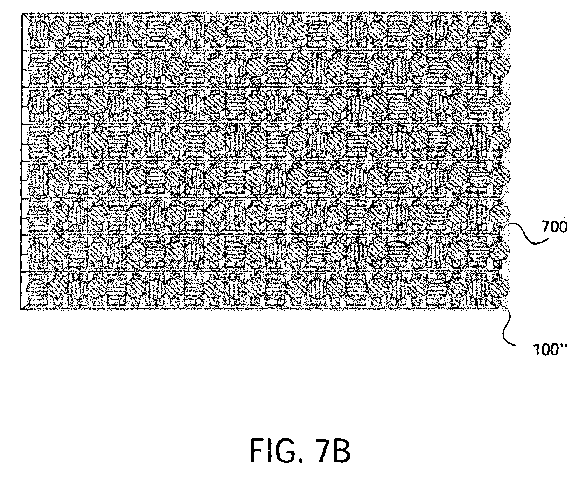

Figure 7A illustrates an alternative inter-color-plane-phase relationship 700 using the green 406, blue 402, and red 404 resample area arrays of Figures 4A, 4B, and 4C. Note that in this inter-color-plane-phase relationship 700 has the same relative phase as the color sub-pixel arrangement 100 as illustrated in Figure 7B. Note that the relative phases of the resample points of this inter-color-plane-phase relationship 700 is the same as that for the inter-color-plane-phase relationship 610. If this inter-color-plane-phase relationship 700 were used for the "one-to-one" data format conversion, the green would again be a unitary filter, while the red and blue would use 3 X 2 coefficient filter kernel:

| | |
|---|---|
| 0.0625 | 0.0625 |
| 0.375 | 0.375 |
| 0.0625 | 0.0625 |

Note that the two columns add up to 0.5 each, similar to the coefficients for the red and blue resample filter operation for the inter-color-plane-phase relationship 610.

This inter-color-plane-phase relationship 700 shown in Figure 7A is useful for scaling, both up and down, of conventional format data sets. The area resample method of calculation of the filter coefficients and keeping track of the input and output data buffers was described in the referenced '058 application. However, according to another embodiment, while the red and blue color planes may be area resampled, it may be advantageous to calculate the filter coefficients for the square grid of green sub-pixels 106 using a novel implementation of a bi-cubic interpolation algorithm for scaling up data sets while converting them to be displayed on the arrangement of color sub-pixels 100 of Figure 1C.

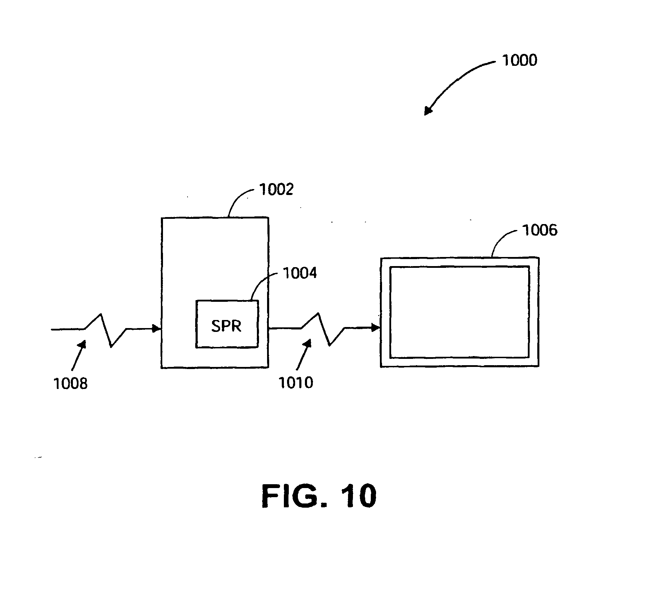

Figure 10 depicts a system 1000 in which a display as constructed in accordance with the various embodiments disclosed herein is driven by a sub-pixel rendering technique 1004 which may be resident on a physical device 1002. An input image data stream 1008 may be input into the sub-pixel rendering technique 1004 and converted in the manner herein disclosed. An output image data stream 1010 is sent to the display device 1006 in order to drive the various sub-pixels to form an image thereupon. As discussed in several of the referenced applications, the sub-pixel rendering (SPR) technique 1004 may be implemented in either hardware and/or software or a combination thereof. For example, SPR techniques 1004 could be resident as logic (either hardware or software) on the display itself or it could reside on a graphics controller chip or board.

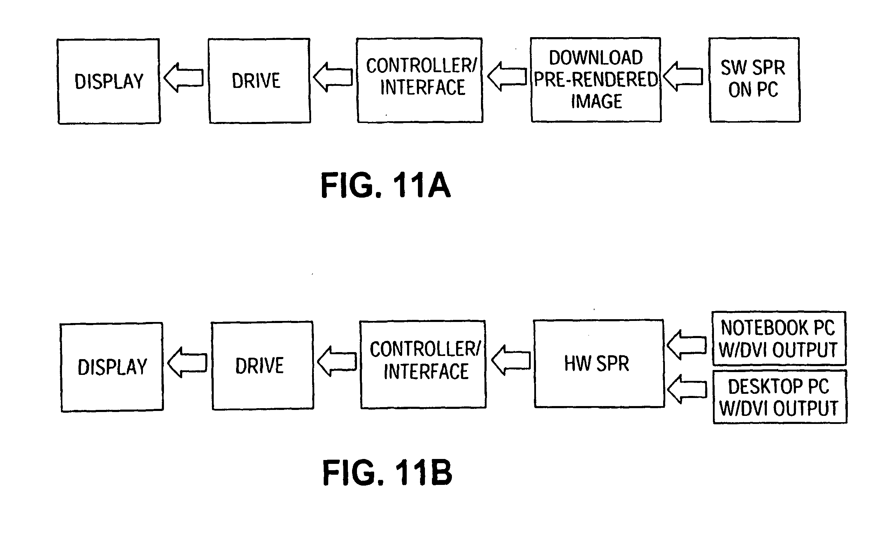

Figures 11A and 11B depict two particular flowchart embodiments disclosing sub-pixel rendering in software and hardware respectively. In Figure 11A, SPR may be accomplished in advance on a PC or other processing system and/or means. From there, the pre-rendered images could be downloaded to a controller/interface and sent along to a drive running the display. In Figure 11B, image data may be input from many different sources - for example, a notebook PC with DVI output or a desktop with DVI output - to a hardware module doing SPR. From there, the sub-pixel rendered data could be sent ultimately to the display via a controller/interface and a drive. Of course, other hardware and software implementations are possible and that Figures 11A and 11B merely describe two possible such implementations.

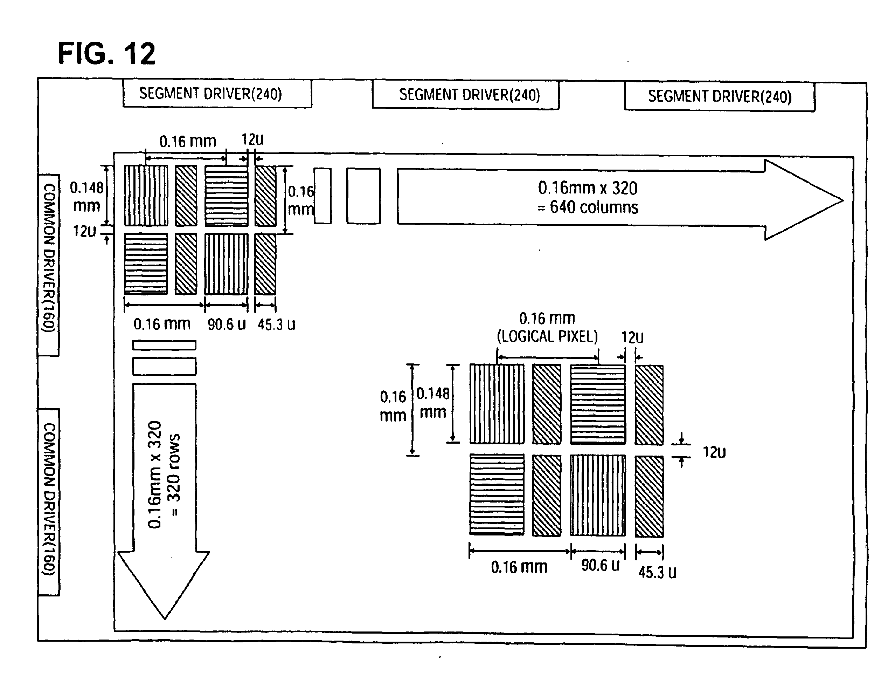

Figure 12 shows one particular display embodiment for a 320x320 STN display using the sub-pixel repeat cell as disclosed herein. Although various sub-pixel dimensions are also disclosed in Figure 12, it should be appreciated that other dimensions would also suffice and that Figure 12 is merely offered for illustrative purposes for a single embodiment.

While the invention has been described with reference to exemplary embodiments, it will be understood that various changes may be made and equivalents maybe substituted for elements thereof without departing from the scope of the invention. In addition, many modifications may be made to adapt a particular situation or material to the teachings without departing from the essential scope thereof. For example, some of the embodiments above may be implemented in other display technologies such as Organic Light Emitting Diode (OLED), ElectroLumenscent (EL), Electrophoretic, Active Matrix Liquid Crystal Display (AMLCD), Passive Matrix Liquid Crystal display (AMLCD), Incandescent, solid state Light Emitting Diode (LED), Plasma Display Panel (PDP), and Iridescent. Therefore, it is intended that the invention not be limited to the particular embodiment disclosed as the best mode contemplated for carrying out this invention, but that the invention will include all embodiments falling within the scope of the appended claims.

## Claims

1. A method of converting incoming three-color pixel data (1008) of a first format for rendering onto a display (1006); said display comprising a plurality of a sub-pixel group (120); said sub-pixel group further comprising eight sub-pixels; wherein each said sub-pixel is one of a first color sub-pixel (106), a second color sub-pixel (104) and a third color sub-pixel (102); wherein said sub-pixel group further comprises four sub-pixels of said first color, two sub-pixels of said second color and two sub-pixels of said third color; wherein further said sub-pixels of said second color and said sub-pixels of said third color are alternatingly arranged along two substantially orthogonal directions forming substantially a checkerboard-like pattern wherein said first color sub-pixels are interspersed within the checkerboard-like pattern wherein said first color sub-pixels are interspersed within the checkerboard-like pattern of the second and third color sub-pixels; the method **characterised in that**:
determining an input image sample area for each data point of said incoming three-color pixel data (1008);
determining a resample area (426, 422, 424) for each color sub-pixel in the display (1006);
forming a set of coefficients for each resample area (426, 422, 424), wherein the set of coefficients comprises one or more than one coefficient and wherein each coefficient comprises a fraction whose denominator is a function of the resample area (426, 422, 424) and whose numerator is a function of an area of each input image sample area that may partially overlap said resample area (426, 422, 424);
multiplying the incoming three-color pixel data (1008) for each input image sample area by its respective coefficient from the set of coefficients resulting in a product; and
adding for each resample area the products obtained from the set of coefficients related to the respective resample area to obtain a luminance value for each resample area (426, 422, 424).

2. The method as recited in Claim 1 wherein a plurality of resample areas (426) for each same-colored sub-pixel (106) forms a resample area array (406); and wherein the method further comprises:
determining a phase relationship (400) between the resample area arrays (406, 402, 404) for each color sub-pixel (106, 104, 102).

3. The methods as recited in Claim 2 wherein determining a phase relationship further comprises:
positioning resample points (416, 412, 414) for each said color resample areas (426, 422, 424) such that the resample points (414, 412) for said second color and said third color substantially overlay the resample points (416) for said first color.

4. The method as recited in Claim 1 wherein said first color is green, and said second and third colors are red and blue respectively;
wherein said set of coefficients for said resample areas (426) for the green color comprises a unity filter; and
wherein said set of coefficients for said resample areas (424, 422) for the red and blue colors are each a 3x3 filter coefficient matrix.

5. The method as recited in Claim 4 wherein said unity filter is centered to match substantially an input pixel by adjusting said filter with respect to a sub-pixel grid (100).

6. The method as recited in Claim 1 further including testing the incoming three-color pixel data (1008) for a plurality of conditions and taking appropriate actions in response to the outcome of said testing of the incoming three-color pixel data (1008).

7. The method as recited in Claim 6 wherein said incoming three-color pixel data (1008) comprises a sample of a 1x3 matrix of incoming three-color pixel data.

8. The method as recited in Claim 6 wherein said incoming three-color pixel data (1008) comprises a sample of a 1x2 matrix of incoming three-color pixel data.

9. The method as recited in Claim 6 wherein testing the incoming three-color pixel data for a plurality of conditions further comprises:
testing for the detection of a high contrast feature in the incoming three-color pixel data (1008).

10. The method as recited in Claim 6 wherein said high contrast feature comprises one of a group, said group comprising an edge, a line, and a dot.

11. The method as recited in Claim 6 wherein taking appropriate actions in response to the outcome of said testing of the incoming three-color pixel data (1008) further comprises:
substituting a new color data value for a current color data value.

12. The method as recited in Claim 6 wherein taking appropriate actions in response to the outcome of said testing of the incoming three-color pixel data (1008) further comprises:
applying gamma correction to a current color data value.

13. The method as recited in Claim 6 wherein taking appropriate actions in response to the outcome of said testing of the incoming three-color pixel data (1008) further comprises:
applying new sub-pixel rendering filter coefficients to the incoming three-color pixel data (1008).

14. A system comprising:
a display (1006), said display comprising a plurality of a sub-pixel group (120); said sub-pixel group further comprising eight sub-pixels; wherein each said sub-pixel is one of a first color sub-pixel (106), a second color sub-pixel (104) and a third color sub-pixel (102); wherein said sub-pixel group further comprises four sub-pixels of said first color, two sub-pixels of said second color and two sub-pixels of said third color; wherein further said sub-pixels of said second color and said sub-pixels of said third color are alternatingly arranged along two substantially orthogonal directions forming substantially a checkerboard-like pattern wherein said first color sub-pixels are interspersed within the checkerboard-like pattern of the second and third color sub-pixels; and
means for subpixel rendering (1004) incoming three-color pixel (1008), the system **characterised in that** the means for subpixel rendering comprises:
means for determining input image sample area for each data point of said incoming three-color pixel data (1008);
means for determining a resample area (426, 422, 424) for each color sub-pixel (106, 104, 102) in the display;
means for forming a set of coefficients for each resample area (426, 422, 424), wherein the set of coefficients comprises one or more than one coefficient and wherein each coefficient comprises a fraction whose denominator is the resample area (426, 422, 424) and whose numerator is an area of each input image sample area that may partially overlap said resample area (426, 422, 424);
means for multiplying the incoming three-color pixel data (1008) for each input image sample area by a coefficient in the set of coefficients resulting in a product; and
means for adding for each resample area the products obtained from the set of coefficients related to the respective resample area to obtain a luminance value for each resample area (426, 422, 424).

15. The system as recited in Claim 13 wherein said means for subpixel rendering input image data (1008) further comprises:
means for inputting incoming three-color pixel data (1008);
means for testing the incoming three-color pixel data (1008) for a plurality of conditions wherein one of said conditions comprises testing for the presence of high contrast features in the incoming three-color pixel data (1008); and
means for taking appropriate actions in response to the outcome of said testing of the incoming three-color pixel data (1008).

16. The system as recited in Claim 14 wherein said set of color image data comprises a sample of a lx3 matrix of said incoming three-color pixel data(1008).

17. The system as recited in Claim 14 wherein said set of color image input data comprises a sample of a 1x2 matrix of said incoming three-color pixel data (1008).

18. The system as recited in Claim 14 wherein said high contrast feature comprises one of a group, said group comprising an edge, a line, and a dot.

19. The system as recited in Claim 14 wherein means for taking appropriate actions in response to the outcome of said testing of said incoming three-color pixel data (1008) further comprises:
means for substituting a new color data value for a current color data value.

20. The system as recited in Claim 14 wherein means for taking appropriate actions in response to the outcome of said testing of said incoming three-color pixel data (1008) further comprises:
means for applying gamma correction to a current color data value.

21. The system as recited in Claim 14 wherein means for taking appropriate actions in response to the outcome of said testing of said incoming three-color pixel data (1008) further comprises:
means for applying new sub-pixel rendering filter coefficients to the incoming three-color pixel data (1008).

22. The system as recited in Claim 21 wherein a plurality of resample areas (426) for each same-colored sub-pixel (106) forms a resample area array (406); and wherein means for determining the resample area further comprises:
means for determining a phase relationship (400, 610, 700) between the resample area arrays (406, 402, 404) for each color sub-pixel (106, 104, 102).

23. The system as recited in Claim 22 wherein means for determining a phase relationship further comprises:
means for positioning resample points (416, 412, 414) for each said color resample areas (426, 422, 424) such that the resample points (414, 412) for said second color and said third color substantially overlay the resample points (416) for said first color.

24. The system as recited in Claim 21 wherein said first color is green, and said second and third colors are red and blue respectively;
wherein said set of coefficients for said resample areas (426) for the green color comprises a unity filter; and
wherein said set of coefficients for said resample areas (424, 422) for the red and blue colors are each a 3x3 filter coefficient matrix.

25. The system as recited in Claim 23 wherein said unity filter is centered to match substantially an input pixel by adjusting said filter with respect to a sub-pixel grid (100).

## Patentansprüche

1. Verfahren zum Konvertieren eingehender Drei-Farben-Pixeldaten (1008) eines ersten Formats zum Rendern auf eine Anzeige (1006); wobei die Anzeige eine Mehrzahl einer Unterpixelgruppe (120) umfasst; wobei die Unterpixelgruppe ferner acht Unterpixel umfasst; wobei jeder der Unterpixel einer ist aus einem erste-Farbe-Unterpixel (106), einem zweite-Farbe-Unterpixel (104) und einem dritte-Farbe-Unterpixel (102); wobei die Unterpixelgruppe ferner umfasst: vier Unterpixel der ersten Farbe, zwei Unterpixel der zweiten Farbe und zwei Unterpixel der dritten Farbe; wobei ferner die Unterpixel der zweiten Farbe und die Unterpixel der dritten Farbe alternierend entlang zweier im Wesentlichen orthogonaler Richtungen angeordnet sind, ein im Wesentlichen schachbrettartiges Muster formend, wobei die erste-Farbe-Unterpixel innerhalb des schachbrettartigen Musters der zweite- und dritte-Farbe-Unterpixel eingestreut sind; wobei das Verfahren **gekennzeichnet ist durch**:
Bestimmenden einer Eingabeabbildungsauswahlfläche für jeden Datenpunkt der eingehenden Drei-Farben-Pixeldaten (1008);
Bestimmen einer Resampling-Fläche (426, 422, 424) für jeden Farbe-Unterpixel in der Anzeige (1006);
Ausbilden eines Satzes von Koeffizienten für jede Resampling-Fläche (426, 422, 424), wobei der Satz von Koeffizienten einen oder mehr als einen Koeffizienten umfasst und wobei jeder Koeffizienten einen Bruch umfasst, dessen Nenner eine Funktion der Resampling-Fläche (426, 422, 424) ist und dessen Zähler eine Funktion einer Fläche von jeder Eingabeabbildungsauswahlfläche ist, welche teilweise die Resampling-Fläche (426, 422, 424) überlappen kann;
Multiplizieren der eingehenden Drei-Farben-Pixeldaten (1008) für jede Eingabeabbildungsauswahlfläche mit ihren jeweiligen Koeffizienten von dem Satz von Koeffizienten, resultierend in einem Produkt; und
Addieren, für jede Resampling-Fläche, des Produkts, welches aus dem Satz von Koeffizienten, welche sich auf die jeweilige Resampling-Fläche beziehen, erhalten ist, um einen Leuchtdichtewert für jede Resampling-Fläche (426, 422, 424) zu halten.

2. Verfahren nach Anspruch 1, wobei eine Mehrzahl von Resampling-Flächen (426) für jeden gleichfarbigen Unterpixel (106) ein Resampling-Flächen-Array (406) ausbildet; und wobei das Verfahren ferner umfasst:
Bestimmen einer Phasenbeziehung (400) zwischen den Resampling-Flächen-Arrays (406, 402, 404) für jeden Farbe-Unterpixel (106, 104, 102).

3. Verfahren nach Anspruch 2, wobei Bestimmen einer Phasenbeziehung ferner umfasst:
Positionieren von Resampling-Punkten (416, 412, 414) für jede der Farbe-Resampling-Flächen (426, 422, 424), sodass die Resampling-Punkte (414,412) für die zweite Farbe und die dritte Farbe im Wesentlichen die Resampling-Punkte (416) für die erste Farbe überlagern.

4. Verfahren nach Anspruch 1, wobei die erste Farbe grün ist und die zweiten und dritten Farben jeweils rot und blau sind;
wobei der Satz von Koeffizienten für die Resampling-Flächen (426) für die grüne Farbe einen Unity-Filter umfasst; und
wobei der Satz von Koeffizienten für die Resampling-Flächen (424, 422) für die roten und blauen Farben jeweils eine 3x3 Filterkoeffizientenmatrix sind.

5. Verfahren nach Anspruch 4, wobei der Unity-Filter zentriert ist, um im Wesentlichen einem Eingabepixel durch Einstellen des Filters bezüglich eines Unterpixelgitters (100) zu entsprechen.

6. Verfahren nach Anspruch 1, ferner umfassend Testen der eingehenden Drei-Farben-Pixeldaten (1008) auf eine Mehrzahl von Bedingungen und Vornehmen von angemessenen Maßnahmen als Antwort auf den Ausgang des Testens der eingehenden Drei-Farben-Pixeldaten (1008).

7. Verfahren nach Anspruch 6, wobei die eingehenden Drei-Farben-Pixeldaten (1008) eine Auswahl einer 1x3 Matrix von eingehenden Drei-Farben-Pixeldaten umfasst.

8. Verfahren nach Anspruch 6, wobei die eingehenden Drei-Farben-Pixeldaten (1008) eine Auswahl einer 1x2 Matrix von eingehenden Drei-Farben-Pixeldaten umfasst.

9. Verfahren nach Anspruch 6, wobei Testen eingehender Drei-Farben-Pixeldaten auf eine Mehrzahl von Bedingungen ferner umfasst:
Testen auf die Erfassung eines hoch-Kontrast-Merkmals in den eingehenden Drei-Farben-Pixeldaten (1008).

10. Verfahren nach Anspruch 6, wobei das hoch-Kontrast-Merkmal eines aus einer Gruppe umfasst, wobei die Gruppe eine Kante, eine Linie und einen Punkt umfasst.

11. Verfahren nach Anspruch 6, wobei ein Vornehmen geeigneter Maßnahmen als Antwort auf den Ausgang des Testens der eingehenden Drei-Farben-Pixeldaten (1008) ferner umfasst:
Ersetzen eines neuen Farbdatenwerts für einen vorliegenden Farbdatenwert.

12. Verfahren nach Anspruch 6, wobei ein Vornehmen geeigneter Maßnahmen als Antwort auf den Ausgang des Testens der eingehenden Drei-Farben-Pixeldaten (1008) ferner umfasst:
Anwenden einer Gammakorrektur auf einen vorliegenden Farbdatenwert.

13. Verfahren nach Anspruch 6, wobei ein Vornehmen geeigneter Maßnahmen als Antwort auf den Ausgang des Testens der eingehenden Drei-Farben-Pixeldaten (1008) ferner umfasst:
Anwenden neuer Unterpixel-Renderfilter-Koeffizienten auf die eingehenden Drei-Farben-Pixeldaten (1008).

14. System umfassend:
eine Anzeige (1006), wobei die Anzeige eine Mehrzahl von einer Unterpixelgruppe (120) umfasst; wobei die Unterpixelgruppe ferner acht Unterpixel umfasst; wobei jeder der Unterpixel einer ist aus einem erste-Farbe-Unterpixel (106), einem zweite-Farbe-Unterpixel (104) und einem dritte-Farbe-Unterpixel (102); wobei die Unterpixelgruppe ferner umfasst: vier Unterpixel der ersten Farbe, zwei Unterpixel der zweiten Farbe und zwei Unterpixel der dritten Farbe; wobei ferner die Unterpixel der zweiten Farbe und die Unterpixel der dritten Farbe alternierend entlang zweier im Wesentlichen orthogonaler Richtungen angeordnet sind, ein im Wesentlichen schachbrettartiges Muster formend, wobei die erste-Farbe-Unterpixel innerhalb des schachbrettartigen Musters der zweite- und dritte-Farbe-Unterpixel eingestreut sind; und
Mittel zum Unterpixel-Rendern (1004) eingehender Drei-Farben-Pixel (1008) wobei das System **dadurch gekennzeichnet ist, dass** die Mittel zum Unterpixel-Rendern umfassen:
Mittel zum Bestimmenden einer Eingabeabbildungsauswahlfläche für jeden Datenpunkt der eingehenden Drei-Farben-Pixeldaten (1008);
Mittel zum Bestimmen einer Resampling-Fläche (426, 422, 424) für jeden Farbe-Unterpixel (106, 104, 102) in der Anzeige;
Mittel zum Ausbilden eines Satzes von Koeffizienten für jede Resampling-Fläche (426, 422, 424), wobei der Satz von Koeffizienten einen oder mehr als einen Koeffizienten umfasst und wobei jeder Koeffizienten einen Bruch umfasst, dessen Nenner die Resampling-Fläche (426, 422, 424) ist und dessen Zähler eine Fläche von jeder Eingabeabbildungsauswahlfläche ist, welche teilweise die Resampling-Fläche (426, 422, 424) überlappen kann;
Mittel zum Multiplizieren der eingehenden Drei-Farben-Pixeldaten (1008) für jede Eingabeabbildungsauswahlfläche mit einem Koeffizienten in dem Satz von Koeffizienten, resultierend in einem Produkt; und
Mittel zum Addieren, für jede Resampling-Fläche, des Produkts, welches aus dem Satz von Koeffizienten, welche sich auf die jeweilige Resampling-Fläche beziehen, erhalten ist, um einen Leuchtdichtewert für jede Resampling-Fläche (426, 422, 424) zu halten.

15. System nach Anspruch 13, wobei die Mittel zum Unterpixel-Rendern von Eingabeabbildungsdaten (1008) ferner umfassen:
Mittel zum Eingeben eingehender Drei-Farben-Pixeldaten (1008);
Mittel zum Testen der eingehenden Drei-Farben-Pixeldaten (1008) auf eine Mehrzahl von Bedingungen, wobei eine der Bedingungen Testen auf das Vorliegen eines hoch-Kontrast-Merkmals in den eingehenden Drei-Farben-Pixeldaten (1008) umfasst; und
Mittel zum Vornehmen von angemessenen Maßnahmen als Antwort auf den Ausgang des Testens der eingehenden Drei-Farben-Pixeldaten (1008).

16. System nach Anspruch 14, wobei der Satz von Farbabbildungsdaten eine Auswahl einer 1x3 Matrix von den eingehenden Drei-Farben-Pixeldaten (1008) umfasst.

17. System nach Anspruch 14, wobei der Satz von Farbabbildungsdaten eine Auswahl einer 1x2 Matrix von den eingehenden Drei-Farben-Pixeldaten (1008) umfasst.

18. System nach Anspruch 14, wobei das hoch-Kontrast-Merkmal eines aus einer Gruppe umfasst, wobei die Gruppe eine Kante, eine Linie und einen Punkt umfasst.

19. System nach Anspruch 14, wobei Mittel zum Vornehmen geeigneter Maßnahmen als Antwort auf den Ausgang des Testens der eingehenden Drei-Farben-Pixeldaten (1008) ferner umfassen:
Mittel zum Ersetzen eines neuen Farbdatenwerts für einen vorliegenden Farbdatenwert.

20. System nach Anspruch 14, wobei Mittel zum Vornehmen geeigneter Maßnahmen als Antwort auf den Ausgang des Testens der eingehenden Drei-Farben-Pixeldaten (1008) ferner umfassen:
Mittel zum Anwenden einer Gammakorrektur auf einen vorliegenden Farbdatenwert.

21. System nach Anspruch 14, wobei Mittel zum Vornehmen geeigneter Maßnahmen als Antwort auf den Ausgang des Testens der eingehenden Drei-Farben-Pixeldaten (1008) ferner umfassen:
Mittel zum Anwenden neuer Unterpixel-Renderfilter-Koeffizienten auf die eingehenden Drei-Farben-Pixeldaten (1008).

22. System nach Anspruch 21, wobei eine Mehrzahl von Resampling-Flächen (426) für jeden gleichfarbigen Unterpixel (106) ein Resampling-Flächen-Array (406) ausbildet; und wobei Mittel zum Bestimmenden der Resampling-Fläche ferner umfassen:
Mittel zum Bestimmen einer Phasenbeziehung (400, 610, 700) zwischen den Resampling-Flächen-Arrays (406, 402, 404) für jeden Farbe-Unterpixel (106, 104, 102).

23. System nach Anspruch 22, wobei Mittel zum Bestimmen einer Phasenbeziehung ferner umfassen:
Mittel zum Positionieren von Resampling-Punkten (416, 412, 414) für jede der Farbe-Resampling-Flächen (426, 422, 424), sodass die Resampling-Punkte (414, 412) für die zweite Farbe und die dritte Farbe im Wesentlichen die Resampling-Punkte (416) für die erste Farbe überlagern.

24. System nach Anspruch 21, wobei die erste Farbe grün ist und die zweiten und dritten Farben jeweils rot und blau sind;
wobei der Satz von Koeffizienten für die Resampling-Flächen (426) für die grüne Farbe einen Unity-Filter umfasst; und
wobei der Satz von Koeffizienten für die Resampling-Flächen (424, 422) für die roten und blauen Farben jeweils eine 3x3 Filterkoeffizientenmatrix sind.

25. System nach Anspruch 23, wobei der Unity-Filter zentriert ist, um im Wesentlichen einem Eingabepixel durch Einstellen des Filters bezüglich eines Unterpixelgitters (100) zu entsprechen.

## Revendications

1. Procédé de conversion de données entrantes de pixel trichrome (1008) d'un premier format de rendu sur un dispositif d'affichage (1006) ; ledit dispositif d'affichage comprenant une pluralité d'un groupe de sous-pixels (120) ; ledit groupe de sous-pixels comprenant en outre huit sous-pixels ; dans lequel chacun desdits sous-pixels est l'un d'un sous-pixel de première couleur (106), d'un sous-pixel de deuxième couleur (104) et d'un sous-pixel de troisième couleur (102) ; dans lequel ledit groupe de sous-pixels comprend en outre quatre sous-pixels de ladite première couleur, deux sous-pixels de ladite deuxième couleur et deux sous-pixels de ladite troisième couleur ; où en outre lesdits sous-pixels de ladite deuxième couleur et lesdits sous-pixels de ladite troisième couleur sont agencés de manière alternée le long de deux directions substantiellement orthogonales formant substantiellement un motif en damier ; dans lequel lesdits sous-pixels de première couleur sont répartis dans le motif en damier des sous-pixels de deuxième et de troisième couleurs ; le procédé **caractérisé en ce qu'**il consiste :
à déterminer une zone d'échantillonnage d'image d'entrée pour chaque point de données desdites données entrantes de pixel trichrome (1008) ;
à déterminer une zone de ré-échantillonnage (426, 422, 424) pour chaque sous-pixel de couleur dans le dispositif d'affichage (1006) ;
à former un ensemble de coefficients pour chaque zone de ré-échantillonnage (426, 422, 424), où l'ensemble de coefficients comprend un ou plusieurs coefficient(s) et où chaque coefficient comprend une fraction dont le dénominateur est une fonction de la zone de ré-échantillonnage (426, 422, 424) et dont le numérateur est une fonction d'une zone de chaque zone d'échantillonnage d'image d'entrée qui peut chevaucher partiellement ladite zone de ré-échantillonnage ;
à multiplier les données entrantes de pixel trichrome (1008) pour chaque zone d'échantillonnage d'image d'entrée par son coefficient respectif provenant de l'ensemble de coefficients aboutissant à un produit ; et
à additionner pour chaque zone de ré-échantillonnage le produit obtenu à partir de l'ensemble de coefficients relatifs à la zone de ré-échantillonnage respective afin d'obtenir une valeur de luminance pour chaque zone de ré-échantillonnage (426, 422, 424).

2. Procédé selon la revendication 1, dans lequel une pluralité de zones de ré-échantillonnage (426) pour chaque sous-pixel de même couleur (106) forme un réseau de zones de ré-échantillonnage (406) ; et dans lequel le procédé comprend en outre le fait :
de déterminer une relation de phase (400) entre les réseaux de zones de ré-échantillonnage (406, 402, 404) pour chaque sous-pixel de couleur (106, 104, 102).

3. Procédé selon la revendication 2, dans lequel la détermination d'une relation de phase comprend en outre le fait :
de positionner des points de ré-échantillonnage (416, 412, 414) pour chaque zone de ré-échantillonnage de couleur (426, 422, 424) de sorte que les points de ré-échantillonnage (414, 412) pour ladite deuxième couleur et ladite troisième couleur chevauchent substantiellement les points de ré-échantillonnage (416) pour ladite première couleur.

4. Procédé selon la revendication 1, dans lequel ladite première couleur est le vert, et lesdites deuxième et troisième couleurs sont le rouge et le bleu, respectivement ;
dans lequel ledit ensemble de coefficients pour lesdites zones de ré-échantillonnage (426) pour la couleur verte comprend un filtre unitaire ; et
dans lequel ledit ensemble de coefficients pour lesdites zones de ré-échantillonnage (424, 422) pour les couleurs rouge et bleu sont chacune une matrice de coefficient de filtre 3x3.

5. Procédé selon la revendication 4, dans lequel ladite unité de filtre est centrée pour correspondre substantiellement à un pixel d'entrée en réglant ledit filtre par rapport à une grille de sous-pixel (100).

6. Procédé selon la revendication 5, comportant en outre le fait de vérifier les données entrantes de pixel trichrome (1008) pour une pluralité de conditions et de prendre les mesures appropriées en réponse au résultat de ladite vérification des données entrantes de pixel trichrome (1008).

7. Procédé selon la revendication 6, dans lequel lesdites données entrantes de pixel trichrome (1008) comprennent un échantillon d'une matrice 1x3 de données entrantes de pixel trichrome.

8. Procédé selon la revendication 6, dans lequel lesdites données entrantes de pixel trichrome (1008) comprennent un échantillon d'une matrice 1x2 de données entrantes de pixel trichrome.

9. Procédé selon la revendication 6, dans lequel la vérification des données entrantes de pixel trichrome pour une pluralité de conditions comprenant en outre le fait :
de vérifier la détection d'une caractéristique de contraste élevé dans les données entrantes de pixel trichrome (1008).

10. Procédé selon la revendication 6, dans lequel ladite caractéristique de contraste élevé comprend un élément d'un groupe, ledit groupe comprenant un bord, une ligne, et un point.

11. Procédé selon la revendication 6, dans lequel la prise de mesures appropriées en réponse au résultat de ladite vérification des données entrantes de pixel trichrome (1008) comprend en outre le fait :
de substituer une valeur actuelle de données de couleur par une nouvelle valeur de données de couleur.

12. Procédé selon la revendication 6, dans lequel la prise de mesures appropriées en réponse au résultat de ladite vérification des données entrantes de pixel trichrome (1008) comprend en outre le fait :
d'appliquer une correction gamma à une valeur actuelle de données de couleur.

13. Procédé selon la revendication 6, dans lequel la prise de mesures appropriées en réponse au résultat de ladite vérification des données entrantes de pixel trichrome (1008) comprend en outre le fait :
d'appliquer de nouveaux coefficients de filtre de rendu de sous-pixel aux données entrantes de pixel trichrome (1008).

14. Système comprenant :
un dispositif d'affichage (1006), ledit dispositif d'affichage comprenant une pluralité d'un groupe de sous-pixels (120) ; ledit groupe de sous-pixels comprenant en outre huit sous-pixels ; dans lequel chacun desdits sous-pixels est l'un parmi un sous-pixel de première couleur (106), un sous-pixel de deuxième couleur (104) et un sous-pixel de troisième couleur (102) ; dans lequel ledit groupe de sous-pixels comprend en outre quatre sous-pixels de ladite première couleur, deux sous-pixels de ladite deuxième couleur et deux sous-pixels de ladite troisième couleur ; où en outre lesdits sous-pixels de ladite deuxième couleur et lesdits sous-pixels de ladite troisième couleur sont agencés de manière alternée le long de deux directions substantiellement orthogonales formant substantiellement un motif en damier, où lesdits sous-pixels de première couleur sont répartis dans le motif en damier des sous-pixels de deuxième et de troisième couleurs ; et
un moyen pour un rendu de sous-pixel (1004) de pixel trichrome entrant (1008), le système étant **caractérisé en ce que** le moyen pour un rendu de sous-pixel comprend :
un moyen pour déterminer une zone d'échantillonnage d'image d'entrée pour chaque point de données desdites données entrantes de pixel trichrome (1008) ;
un moyen pour déterminer une zone de ré-échantillonnage (426, 422, 424) pour chaque sous-pixel de couleur (106, 104, 102) dans le dispositif d'affichage ;
un moyen pour former un ensemble de coefficients pour chaque zone de ré-échantillonnage (426, 422, 424), dans lequel l'ensemble de coefficients comprend un ou plusieurs coefficient(s) et dans lequel chaque coefficient comprend une fraction dont le dénominateur est la zone de ré-échantillonnage (426, 422, 424) et dont le numérateur est une zone de chaque zone d'échantillonnage d'image d'entrée qui peut chevaucher partiellement ladite zone de ré-échantillonnage (426, 422, 424) ;
un moyen pour multiplier les données entrantes de pixel trichrome (1008) pour chaque zone d'échantillonnage d'image d'entrée par un coefficient dans l'ensemble de coefficients aboutissant à un produit ; et
un moyen pour ajouter pour chaque zone de ré-échantillonnage les produits obtenus à partir de l'ensemble de coefficients relatifs à la zone de ré-échantillonnage respective pour obtenir une valeur de luminance pour chaque zone de ré-échantillonnage (426, 422, 424).

15. Système selon la revendication 13, dans lequel ledit moyen pour un rendu de sous-pixel de données d'image d'entrée (1008) comprend en outre :
un moyen pour introduire des données entrantes de pixel trichrome (1008) ;
un moyen pour vérifier les données entrantes de pixel trichrome (1008) pour une pluralité de conditions où l'une desdites conditions comprend le fait de vérifier la présence de caractéristiques de contraste élevé dans les données entrantes de pixel trichrome (1008) ; et
un moyen pour prendre des mesures appropriées en réponse au résultat de ladite vérification des données entrantes de pixel trichrome (1008).

16. Système selon la revendication 14, dans lequel ledit ensemble de données d'image de couleur comprend un échantillon d'une matrice de 1x3 desdites données entrantes de pixel trichrome (1008).

17. Système selon la revendication 14, dans lequel ledit ensemble de données entrantes d'image de couleur comprend un échantillon d'une matrice de 1x2 desdites données entrantes de pixel trichrome (1008).

18. Système selon la revendication 14, dans lequel ladite caractéristique de contraste élevé comprend un élément d'un groupe, ledit groupe comprenant un bord, une ligne, et un point.

19. Système selon la revendication 14, dans lequel un moyen pour prendre des mesures appropriées en réponse au résultat de ladite vérification desdites données entrantes de pixel trichrome (1008) comprend en outre :
un moyen pour substituer une valeur actuelle de données de couleur par une nouvelle valeur de données de couleur.

20. Système selon la revendication 14, dans lequel un moyen pour prendre des mesures appropriées en réponse au résultat de ladite vérification desdites données entrantes de pixel trichrome (1008) comprend en outre :
un moyen pour appliquer une correction gamma à une valeur actuelle de données de couleur.

21. Système selon la revendication 14, dans lequel un moyen pour prendre des mesures appropriées en réponse au résultat de ladite vérification desdites données entrantes de pixel trichrome (1008) comprend en outre :
un moyen pour appliquer de nouveaux coefficients de filtre de rendu de sous-pixel aux données entrantes de pixel trichrome (1008).

22. Système selon la revendication 21, dans lequel une pluralité de zones de ré-échantillonnage (426) pour chaque sous-pixel de même couleur (106) forme un réseau de zones de ré-échantillonnage (406) ; et
dans lequel un moyen pour déterminer la zone de ré-échantillonnage comprend en outre :
un moyen pour déterminer une relation de phase (400, 610, 700) entre les réseaux de zones de ré-échantillonnage (406, 402, 404) pour chaque sous-pixel de couleur (106, 104, 102) .

23. Système selon la revendication 22, dans lequel un moyen pour déterminer une relation de phase comprend en outre :
un moyen pour positionner des points de ré-échantillonnage (416, 412, 414) pour chacune desdites zones de ré-échantillonnage de couleur (426, 422, 424) de sorte que les points de ré-échantillonnage (414, 412) pour ladite deuxième couleur et ladite troisième couleur chevauchent substantiellement les points de ré-échantillonnage (416) pour ladite première couleur.

24. Système selon la revendication 21, dans lequel ladite première couleur est le vert, et lesdites deuxième et troisième couleurs sont le rouge et le bleu, respectivement ;
dans lequel ledit ensemble de coefficients pour lesdites zones de ré-échantillonnage (426) pour la couleur verte comprend un filtre unitaire ; et
dans lequel ledit ensemble de coefficients pour lesdites zones de ré-échantillonnage (424, 422) pour les couleurs rouge et bleue sont chacun une matrice de coefficient de filtre de 3x3.

25. Système selon la revendication 23, dans lequel ledit filtre unitaire est centré pour correspondre substantiellement à un pixel d'entrée par réglage dudit filtre par rapport à une grille de sous-pixel (100).
